# EUROPEAN PATENT APPLICATION

(11) **EP 3 588 147 A1**
(43) Date of publication of application: **01.01.2020**
(21) Application number: 18180368.5
(22) Date of filing: 28.06.2018
(51) Int. Cl.: G02B 3/08, F21V 5/04, G02B 19/00, H01L 33/58, F21W 131/103, F21Y 115/10

(54) **A LENS AND A LIGHTING UNIT USING THE LENS**

(71) Applicant: Signify Holding B.V., 5656 AE Eindhoven (NL)
(72) Inventor: The designation of the inventor has not yet been filed
(74) Representative: Verweij, Petronella Daniëlle

(57) **Abstract**

The invention provides a lens (30) for providing far-field wide-beam illumination, the lens (30) having a beam-shaping part which combines a diverging central area and converging outer regions based on Fresnel teeth. The teeth provide convergence to spatially different convergence locations (60).

## Description

### FIELD OF THE INVENTION

This invention relates to a lens for providing a diverging beam.

### BACKGROUND OF THE INVENTION

Convex lenses are typically used for providing uniform lighting with large beam angles.

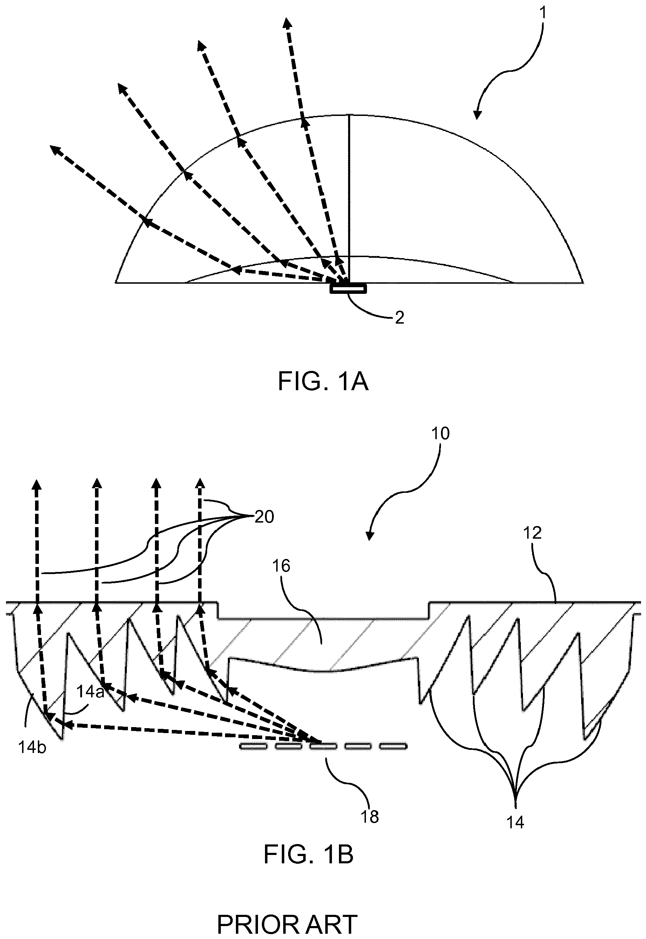

Figure 1A shows a typical convex lens 1 provided over an LED chip 2. Typically, only one or a small number of LEDs can be provided in one lens unit, otherwise, the optical performance is difficult to achieve due to need to have a limited lens diameter. The lens is also thick.

Figure 1B shows a typical Fresnel lens 10, which is widely used for spot lighting, especially for producing a very narrow beam angle. The lens comprises a planar (or stepped) output side 12 and an input side which has a central convex lens portion 16 and a radially outer set of Fresnel teeth 14. The Fresnel teeth each have a first inner surface 14a facing the light source 18 which provides refraction of the light from the light source towards an outer surface 14b facing away from the light source. There is total internal reflection at the outer surface 14b which then redirects the light to the planar surface 12. The collimated light output rays 20 are shown.

A Fresnel lens is often used to create a narrow beam for spot lighting, based on chip on board (COB) LEDs, and multiple mid-power LEDs. This is possible because of the larger diameter. A Fresnel lens also has the advantage of a thinner profile.

There remains a need for a lens design which produces a wide beam in the far-field, which is compact but which also enables high intensity illumination, for example by enabling use with a number of LED light sources while providing suitable thermal management.

### SUMMARY OF THE INVENTION

The invention is defined by the claims.

According to examples in accordance with an aspect of the invention, there is provided a lens for providing wide beam illumination from a light source, comprising:
a lens body comprising a light entry side and a light exit side, wherein in cross section the lens body comprises a beam shaping portion having an optical axis, wherein a light source location is defined in the vicinity of the light entry side, wherein the beam shaping portion comprises:
a central portion, with respect to the optical axis, on the light entry side facing the light source location and adapted to direct light output from the light source location as a diverging beam; and
Fresnel tooth portions on the light entry side and on both lateral sides of the optical axis, wherein the Fresnel tooth portions are adapted to direct light output from the light source location as a reflected beam which converges towards the optical axis,
wherein tooth portions on opposite sides of the central portion are adapted to direct light output from the light source location as converging beams which converge to a set of different convergence locations on the light exit side.

This lens design makes use of a central portion to create a diverging beam. The divergence may correspond to the divergence of the light source at the light source location (i.e., the central portion does not perform any beam shaping), or it may be increased by a diverging concave lens. This central portion provides beam processing for light from the light source location close to the normal, i.e. the optical axis. For light more angularly spaced from the optical axis, a reflective Fresnel tooth type structure is used, i.e. one which provides light which leaves the lens body by reflection (total internal reflection). This light is made to converge, and in particular by more than is required for collimation. Thus, the light converges to crossing points by means of the Fresnel tooth portions.

Note that the cross section is taken in a plane which includes the optical axis and which corresponds to a minimum lateral width. For a circular lens, this will be a plane which includes both a diameter line and the optical axis. As will be explained below. the beam shaping portion maybe circular or it maybe annular. The shape of the beam shaping portion is defined above in a two-dimensional cross section. This cross section is thus one slice through a three dimensional shape. The three dimensional shape may be a circular disc shape or it may be an annular disc shape (i.e. a doughnut shape).

The crossing points are defined above in the cross sectional view. For a circular disc shape, the crossing points associated with each cross section may coincide at single point. For the annular disc shape, the crossing points associated with each cross section may form a ring of crossing points.

Note that for the annular design, the "central portion" is central with regard to the beam shaping portion, i.e. locally central, and not central with regard to the overall lens shape. Instead, the beam shaping portion forms an annulus around a central axis of the overall lens.

The convergence locations, i.e. crossing points, are nearer to the lens body than the intended surface to be illuminated, so that by the time the light reaches the surface to be illuminated, the light forms a diverging beam, both from the central portion and from the outer Fresnel area. By arranging the different lens to have different crossing points, thermal management is easier in that locations of high intensity are positionally separated. In this way, it becomes possible to increase the lighting power that can be used with the lens, while providing a wide far-field illumination intensity distribution.

Note that a light source location is defined simply for the purposes of defining the lens function. This light source location is a point location which is on the optical axis. The lens may be used with a point light source at that light source location. However, it may be used with a light source which extends over an area which includes the light source location. For example, an array of LEDs may be positioned overlapping with light source location. There does not need to be a light source at the actual light source location. The light source location may for example represent the center of area of an array of light source, without there necessarily being a light source at that location.

The central portion may define a concave lens. Thus, there is additional divergence provided to the light in the central area.

The light exit side of the lens body may be flat on a macroscopic scale. This enables a compact lens design, in that it is generally flat. The term "macroscopic scale" is intended to indicate that a surface pattern is not taken into account.

The distance between the convergence locations and the light exit side of the lens body is for example of the same order of magnitude as the aperture of the lens, so between 0.1 and 5 times the maximum diameter of the lens. The distance may be instead be between 0.1 and 10 times the maximum diameter of the lens.

This is before the intended surface to be illuminated, so that the localized high intensity points are not present at the intended illumination distance.

The lens body may further comprise an array of surface structures such as micro-lenses, or other surface texture on the light exit side. These lenses or other structures may be used to provide improved performance such as color separation and to avoid artefacts.

The beam shaping portion may for example comprise 3 to 5 pairs of Fresnel tooth portions. This provides a simple structural design, which is able to provide a uniform lighting distribution at the intended illumination distance.

In a first set of examples, the lens body is rotationally symmetric about a central axis and comprises an annular beam shaping region extending around said central axis, such that said cross section comprises two beam shaping portions.

This is a first design, in which the light source locations (and hence the light sources) form an annular area about a central axis. The lens body is not rotationally symmetric about the individual optical axes, but is rotationally symmetric about a central axis. The divergence formed by the central portion, which is annular for the overall lens, may correspond to the divergence of the light source at the light source location, or it may be increased by a diverging concave lens such as a part-toroidal lens. This provides a structure which can provide a higher light intensity by using an array of light sources. There may be tens or even hundreds of individual light sources.

Each Fresnel tooth portion in said cross section is then a cross section of a different annular Fresnel tooth. This follows from the use of annular Fresnel teeth which do not extend around the optical axis, but extend around a different central axis.

The lens body may comprise a central non-beam shaping region around the central axis. This central region functions only as a spacer.

In a second set of examples, the lens body is rotationally symmetric about the optical axis, and opposing Fresnel tooth portions in said cross section are then cross sections of the same annular Fresnel tooth.

This is a second design, in which the light source location is at the center of the lens body and the lens body is rotationally symmetric about the single optical axis. This provides a compact structure.

The invention also provides a lighting unit comprising:
a lens having the annular first design as defined above; and
an annular array of light sources aligned with the central portions of the beam shaping portions.

The invention also provides a lighting unit comprising:
a lens having the circular second design as defined above; and
a light source or an array of light sources centered at the light source location.

The lighting unit is for example for providing a wide beam far-field illumination to a receiving surface at a distance of more than 2 meters from the lighting unit. The lighting unit is for example for high bay luminaires, which may be both indoor or outdoor. Road lighting is one example.

The lighting unit may have a batwing light output intensity distribution. This is particularly suitable for road lighting applications.

These and other aspects of the invention will be apparent from and elucidated with reference to the embodiment(s) described hereinafter.

### BRIEF DESCRIPTION OF THE DRAWINGS

Examples of the invention will now be described in detail with reference to the accompanying drawings, in which:
Figures 1A and 1B shows a typical convex lens and a typical Fresnel lens, respectively;
Figures 2A and 2B show cross sections of a beam shaping portion of two examples of lens design in accordance with examples of the invention;
Figure 3 shows how light rays converge and diverge in the lens of Figure 2;
Figures 4A-4C show an annular lens design which makes use of the beam shaping portion of Figure 2;
Figure 5 shows a clearer plan view of the lens design of Figure 4; and
Figure 6 shows a batwing light output intensity distribution which is of particular interest for a road lighting application.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

The invention provides a lens for providing far-field wide beam illumination, which has a beam shaping part which combines a diverging central area and converging outer regions based on Fresnel teeth. Symmetric or asymmetric pairs of teeth provide convergence to spatially different convergence locations. This lens design makes use of a locally central portion (central to the beam shaping part) to create a diverging beam. The divergence may correspond to the divergence of the light source at the light source location, or it may be increased by a diverging concave lens. The Fresnel teeth also provide divergence in the far field, after crossing at different points in the near field.

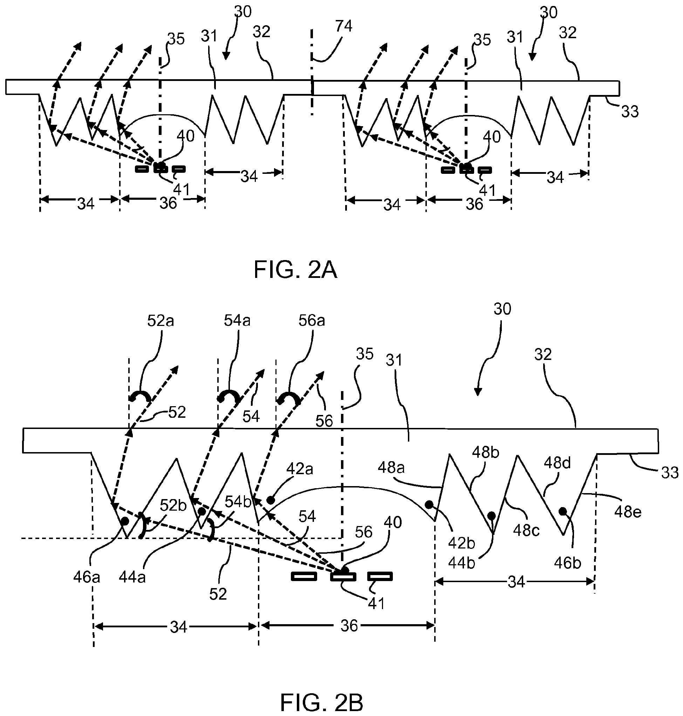

Figure 2A shows a cross section of the lens design for an annular disc shaped lens (i.e. a doughnut shape) and Figure 2B shows a cross section for a circular disc shaped lens.

The cross section of Figure 2A thus has two beam shaping portions, symmetrical about a central axis 74 of the overall lens, whereas the cross section of Figure 2B has only one beam shaping portion. The function of each of the two beam shaping portions in Figure 2A is the same as for the single beam shaping portion of Figure 2B. More features are given reference numbers in Figure 2B, whereas Figure 2A is kept uncluttered.

The function of the circular and annular lenses will become clear from the description below.

The lens 30 comprises a lens body 31 comprising a light entry side 33 and a light exit side 32. In cross section, the lens body comprises a beam shaping portion (i.e. the cross section shown in Figure 2) having an optical axis 35, wherein a light source location 40 is defined in the vicinity of the light entry side 33 and along the optical axis 35. For the purposes of this explanation of the lens function, the light source location is taken to be a single point in the cross section.

The cross section is taken in a plane which includes the optical axis 35 and which corresponds to a minimum lateral width of the beam shaping portion. For both the circular lens and annular lens designs, this cross sectional plane will be a plane which includes both a diameter line and the optical axis 35.

The shape of the beam shaping portion will be explained with reference to the cross section shown.

The beam shaping portion comprises a central portion 36, namely a portion which through which the optical axis passes, on the light entry side 33 facing the light source location 40. This central portion is adapted to direct light output from the light source location as a diverging beam. This may be achieved by having no beam shaping (since the light source output is diverging) or a concave lens shape may be used as is shown in Figures 2A and 2B.

Fresnel tooth portions are provided on the light entry side 33 on both lateral sides of the optical axis 35, in radially outer regions 34. In the example shown, there are six tooth portions arranged as three pairs. An innermost pair is shown as 42a and 42b, a middle pair is shown as 44a and 44b and an outermost pair is shown as 46a and 46b.

Each tooth portion has a first surface facing the light source location 40 (i.e. the solid lens body is on the outer side of the first surface). These first surfaces are shown as 48b and 48d in Figure 2B. Note that the outer edge of the concave lens may be considered to define a first surface of the innermost tooth portions 42a and 42b.

The first surfaces are arranged with an angle below the critical angle for light received from the light source location (or more generally from the locations where the light sources will be present). Thus, the light passes into the body of the lens (i.e. it crosses a low to high refractive index boundary). There is thus refraction, for all light which is not incident along a normal direction of incidence.

Each tooth portion also has a second surface facing away from the light source location 40 (i.e. the solid lens body is on the inner side of the second surface). These second surfaces are shown as 48a, 48c and 48e in Figure 2.

The second surfaces are arranged with an angle above the critical angle for light received from the light source location (or more generally from the locations where the light sources will be present). Thus, the light is reflected out of the body of the lens by total internal reflection from a high to low refractive index boundary. This reflected light is below the critical angle for the final refractive index boundary at the light exit side 32 of the lens.

For the annular design of Figure 2A, each tooth portion of one of the beam shaping portions is part of a different tooth, and those teeth extend around the central axis of the overall lens. For the circular design of Figure 2B, the pairs of tooth portions (e.g. 42a and 42b) are each part of a single annular tooth which extends around the (local) optical axis.

The Fresnel tooth portions reflect light output from the light source location as a beam which converges towards the optical axis 35.

By way of example, three light sources 41 are shown in Figures 2A and 2B, centered at the light source location 40 and light rays are shown for the light source at the light source location 40.

A first light ray 52 is directed to the outermost tooth portion 46a. It meets a refractive first surface of that tooth portion, and then after refraction is reflected by total internal reflection from a second surface of that tooth portion 46a. The angles of inclination of the two surfaces (including the angle 52b of the first surface) determine the eventual light exit angle 52a for the light ray 52.

A second light ray 54 is directed to the middle tooth portion 44a. It meets a refractive first surface of that tooth portion, and then after refraction is reflected by total internal reflection from a second surface of that tooth portion 44a. The angles of inclination of the two surfaces again determine the eventual light exit angle 54a for the light ray 54.

A third light ray 56 is directed to the innermost tooth portion 42a. It meets a refractive first surface of that tooth portion, and then after refraction is reflected by total internal reflection from a second surface of that tooth portion 42a. The angles of inclination of the two surfaces again determine the eventual light exit angle 56a for the light ray 56.

The angles 52a, 54a, 56a may thus be selected by design of the lens, including the angles 52b and 54b. They converge towards the optical axis 35 but they cross at different positions.

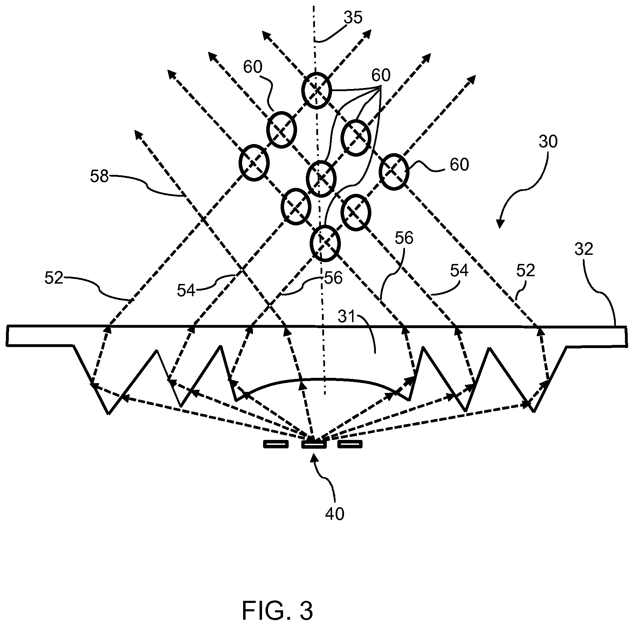

This is shown in Figure 3 which shows light rays to both lateral sides for a single beam shaping portion. The tooth portions comprise pairs disposed on opposite sides of the central portion i.e., on opposite lateral sides of the optical axis 35, wherein each pair is adapted to direct light output from the light source location as a converging beam. The pairs are not necessarily symmetric pairs, and there are other crossing points resulting from non-symmetric pairs, as can be seen in Figure 3. Preferably, the crossing points from any pair of tooth portions (for example, for the rays reaching the middle of the reflecting facet) are all at different spatial locations. Thus, the beams converge to a corresponding convergence location 60 on the light exit side 32 and the convergence locations are different.

Figure 3 shows the rays directed from the assumed single point light source location 40 to the center of each of the six reflecting facets, and it shows that the nine corresponding crossing points 60 are all at different spatial locations. The three crossing points from symmetrical pairs are along the optical axis 35 and the other six crossing points are at other locations to the lateral sides of the optical axis. Of course, light beams directed to different positions along the Fresnel teeth will also give other output beam directions. In the example of Figure 3, the general directional effect of each tooth may be considered to be represented by the single beam shown for each tooth portion.

The convergence locations are crossing points for pairs of light paths in the cross section shown. They are nearer to the lens body 31 than the intended surface to be illuminated, so that by the time the light reaches the surface to be illuminated, the light forms a diverging beam as can be seen in Figure 3. For example, the distance between the convergence locations 60 and the light exit side 32 surface of the lens body 31 is of the same order of magnitude as the aperture of the lens i.e., the lens diameter.

By arranging the different pairs of tooth portions to have different crossing points, based on the angles of the tooth portion surfaces, thermal management is easier in that locations of high intensity are positionally separated. In this way, it becomes possible to increase the lighting power that can be used with the lens, while providing a desired broad far field illumination intensity distribution.

The light exit side 32 of the lens body is generally flat (i.e. on a macroscopic scale).

The beam shaping portion is shown with three pairs of Fresnel tooth portions, but there may for example be three, four or five pairs of tooth portions. This provides a simple structural design, which is able to provide a uniform lighting distribution at the intended illumination distance.

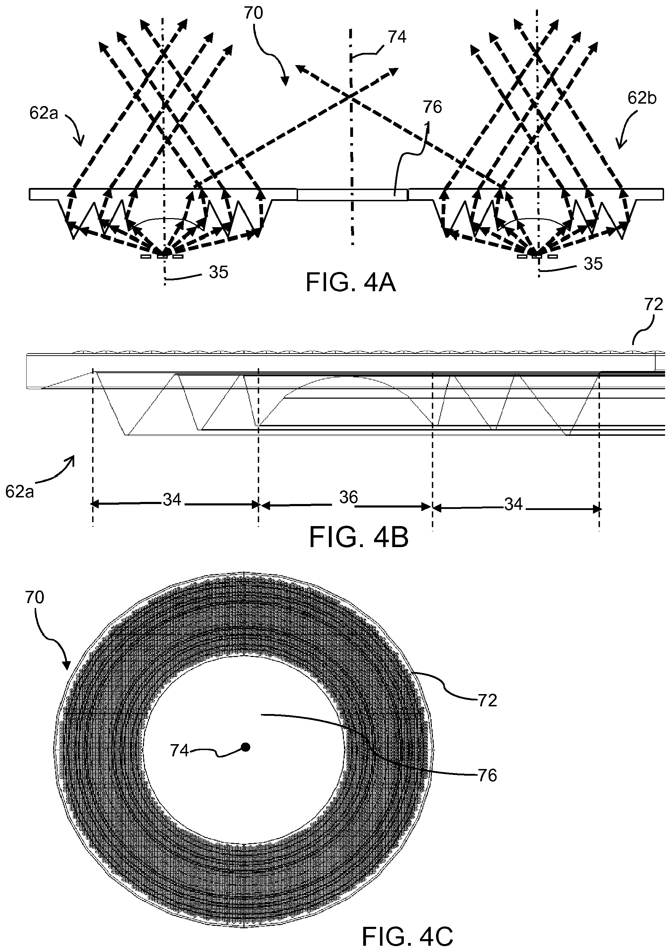

Figure 4 shows the annular design in more detail. Figure 4A shows a cross section of the whole lens 70 and corresponds to Figure 2A, but it shows a larger central region of the overall lens.

The lens 31 body is rotationally symmetric about a central axis 74 and comprises an annular beam shaping region extending around the central axis 74, such that the cross section comprises two beam shaping portions 62a and 62b.

Figure 4B shows an enlarged part of one of the beam shaping portions 62a. The light source locations (and hence the light sources) form an annular area about the central axis. The lens body is not rotationally symmetric about the individual optical axes 36, but is rotationally symmetric about the central axis 74. Figure 4B also shows that the flat surface (the light exit side) has an array 72 of microlenses.

Figure 4C shows a plan view. It shows that the lens body comprises a central non-beam shaping region 76 around the central axis 74.

As in the example above, the divergence formed by the central portion 36, which is annular, may correspond to the divergence of the light source at the light source location, or it may be increased by a diverging concave lens such as a part-toroidal lens. This provides a structure which can provide a higher light intensity by using an array of light sources. There may be tens or even hundreds of individual light sources.

Each Fresnel tooth portion in the cross section of an individual beam shaping portion cross section (i.e. the left half of Figure 4A or the right half of Figure 4A) is in this case part of a different annular Fresnel tooth. The teeth are annular about the central axis 74 as can be seen in Figure 4C.

The micro-lenses 72, or indeed other surface textures, may be used to provide improved performance such as color separation and to avoid artefacts.

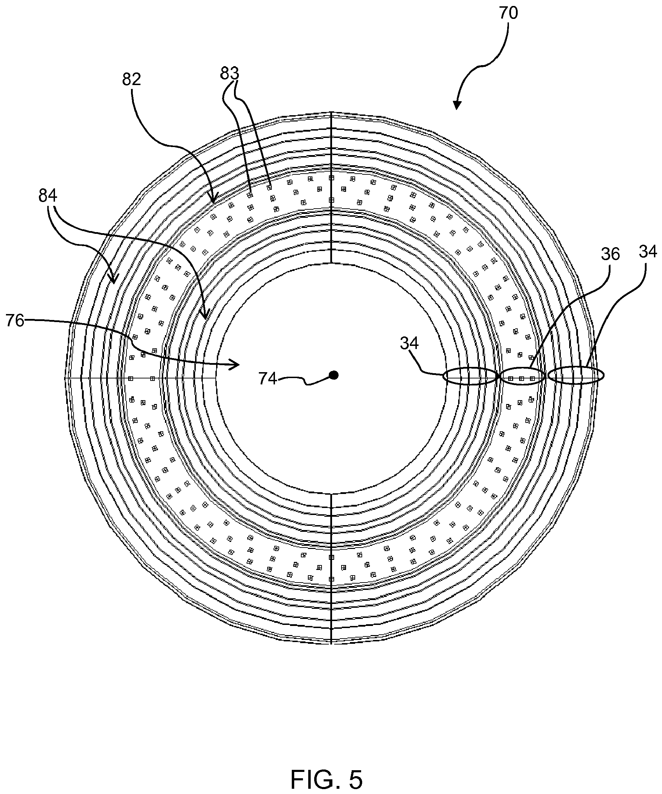

Figure 5 shows a clearer plan view, which shows the annular array 82 of light sources 83 more clearly, which are aligned with the central portions 36 of the beam shaping portions 62a, 62b. The annular Fresnel teeth are shown as the ridges 84.

The area of the annular band which defines the location for the LEDs is much larger than a central circular area. This means it is possible to place more LEDs , or else the same number of LED chips may be used but the distance between the LED chips may be made greater so that the thermal management is easier.

The lens design is rotational, having a central ring shaped lens (the portions 36) and two or more than two tooth pairs.

The angles of the tooth faces are different to a conventional Fresnel lens design for a narrow beam angle.

By way of example, the angle of the first surfaces of the Fresnel teeth to the general plane of the lens is from 65 to 80 degrees, for example from about 70 degrees to 75 degrees. For example, with reference to Figure 2, the angle 52b maybe 70 degrees, and the angle 54b may be 75 degrees.

A narrow beam Fresnel lens usually has corresponding angles of more than 85 degrees, because the emission angle from the tooth total internal reflection surface is typically from 0 to 10 degrees.

For the lens design above for uniform lighting, the first surface angle is from about 65 to 80 degrees because the emission angle (angles 52a, 54a, 56a in Figure 2) from the light exit side 32 is about 30 to 55 degrees. For example, with reference to Figure 2, the angle 52a maybe 48 degrees, the angle 54a maybe 45 degrees and the angle 56a maybe 40 degrees.

The diameter of the lens is comparable to that of a narrow beam Fresnel lens. The spacing of LEDs can be made slightly larger than a narrow beam Fresnel lens due to the wide beam, which is a benefit to the thermal for the lamp.

Although the rays cross before reaching the far field, the focal point of the exit ray is not unique, thereby creating a multiple focus. Therefore, a small part of the ray can converge at a certain receiver. By avoiding convergence for all exit rays at one receiving plane, the impact to the thermal performance at the receiver is reduced.

The lens function has been explained using a single cross section. For a circular disc shaped lens, the light source location in a 3D view will be a single point. Each pair of Fresnel tooth portions are then part of a single Fresnel tooth, and the light from the light source location emitted with a certain light exit angle will converge from all around the Fresnel tooth to a single convergence location. However, by having a slightly oval shape instead of a perfectly circular lens shape the convergence locations may be more spread.

For an annular lens, the light source locations in a 3D view will form a circle. The light from the light source locations emitted with a certain angle (in the cross sectional plane) will converge to a circular ring of convergence locations. Again, the convergence locations can be spread by having slightly oval shape instead of a perfectly annular lens shape. The pairs of Fresnel teeth portions may have angles of their surfaces which are asymmetric about the optical axis 35, in particular since the individual portions are parts of different annular Fresnel teeth.

Similarly, Figure 3 shows the convergence locations 60 along the optical axis 35. This is not essential, and an asymmetric design may provide these convergence locations at different lateral positions as well as at different positions along the optical axis direction.

The typical application for this type of Fresnel lens is that the receiver is far from the lens, for example more than 2 meters or even more than 4 meters distant. The receiver is also thereby far from the focal points of the exit rays.

The lighting unit is for example for high bay luminaires, which may be both indoor or outdoor. Area lighting is one example.

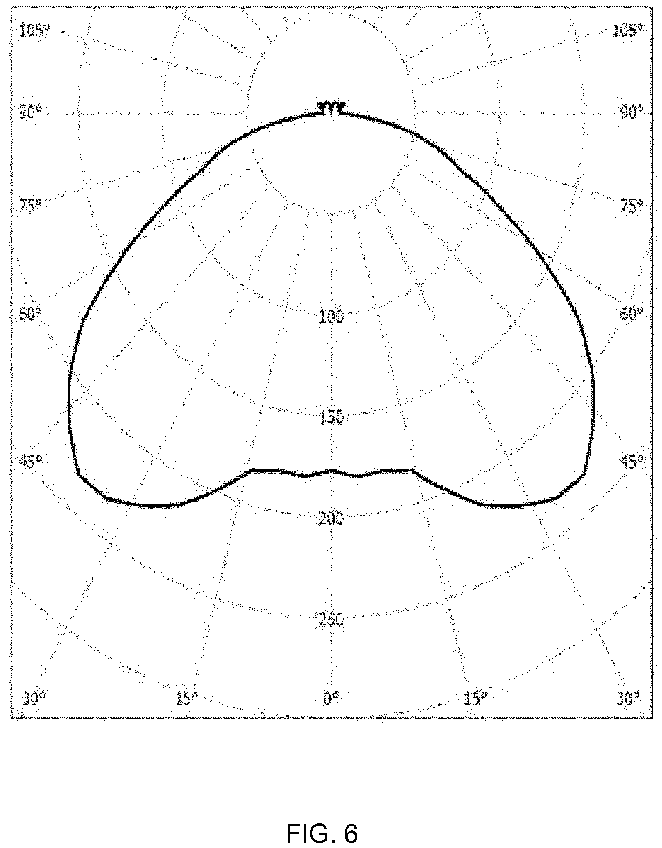

For area lighting applications, the lighting unit may have a batwing light output intensity distribution as shown in Figure 6.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A lens (30) for providing wide beam illumination from a light source (40), comprising:
a lens body (31) comprising a light entry side (33) and a light exit side (32), wherein in cross section the lens body comprises a beam shaping portion having an optical axis (35), wherein a light source location (40) is defined in the vicinity of the light entry side (33), wherein the beam shaping portion comprises:
a central portion (36), with respect to the optical axis, on the light entry side (33) facing the light source location and adapted to direct light output from the light source location (40) as a diverging beam; and
Fresnel tooth portions (42a, 42b; 44a, 44b; 46a, 46b) on the light entry side (33) and on both lateral sides of the optical axis (35), wherein the Fresnel tooth portions are adapted to direct light output from the light source location (40) as a reflected beam which converges towards the optical axis (35),
wherein tooth portions on opposite sides of the central portion (36) are adapted to direct light output from the light source location (40) as converging beams which converge to a set of different convergence locations (60) on the light exit side (32).

2. A lens as claimed in claim 1, wherein the central portion comprises a concave lens.

3. A lens as claimed in any one of claims 1 to 2, wherein the light exit side (32) of the lens body is flat on a macroscopic scale.

4. A lens as claimed in any one of claims 1 to 3, wherein the distance between the convergence locations (60) and the light exit side (32) of the lens body is of the same order of magnitude as the aperture of the lens.

5. A lens as claimed in any one of claims 1 to 4, wherein the lens body further comprises an array of surface structures on the light exit side (32).

6. A lens as claimed in claim 5, wherein the surface structures comprise micro-lenses (72).

7. A lens as claimed in any one of claims 1 to 6, wherein the beam shaping portion comprises 3 to 5 pairs of Fresnel tooth portions.

8. A lens as claimed in any one of claims 1 to 7, wherein the lens body is rotationally symmetric about a central axis (74) and comprises an annular beam shaping region extending around said central axis (74), such that said cross section comprises two beam shaping portions.

9. A lens as claimed in claim 8, wherein the Fresnel tooth portions in said cross section are each part of different annular Fresnel teeth.

10. A lens as claimed in claim 8 or 9, wherein the lens body comprises a central non-beam shaping region (76) around the central axis.

11. A lens as claimed in any one of claims 1 to 7, wherein the lens body is rotationally symmetric about the optical axis (35), and wherein pairs of Fresnel tooth portions in said cross section are each different parts of a single annular Fresnel tooth.

12. A lighting unit comprising:
a lens as claimed in claim 8, 9 or 10; and
an annular array (82) of light sources (83) aligned with the central portions (36) of the beam shaping portions.

13. A lighting unit comprising:
a lens as claimed in claim 11; and
a light source (41) or an array of light sources centered at the light source location (40).

14. A lighting unit as claimed in claim 12 or 13 for providing a wide beam far-field illumination to a receiving surface at a distance of more than 2 meters from the lighting unit.

15. A lighting unit as claimed in any one of claims 12 to 14 having a batwing light output intensity distribution.
